# EUROPÄISCHE PATENTSCHRIFT

(11) **EP 1 017 093 B1**
(45) Veröffentlichungstag und Bekanntmachung des Hinweises auf die Patenterteilung: **18.08.2010**
(21) Anmeldenummer: 99811142.1
(22) Anmeldetag: 13.12.1999
(51) Int. Cl.: H01L 21/332, H01L 21/331, H01L 29/74, H01L 29/739

(54) **Leistungshalbleiterelement und Verfahren zur Herstellung**
Power semiconductor device and process for manufacturing it
Dispositif semi-conducteur de puissance et procédé pour sa fabrication

(30) Priorität: 29.12.1998 DE 19860581
(43) Veröffentlichungstag der Anmeldung: 05.07.2000
(73) Patentinhaber: ABB Technology AG, 8050 Zürich (CH)
(72) Erfinder: Linder, Stefan, Dr., 4800 Zofingen (CH)
(74) Vertreter: ABB Patent Attorneys

(56) Entgegenhaltungen:
- EP-A- 0 700 095
- EP-A- 0 702 401
- PATENT ABSTRACTS OF JAPAN vol. 9, no. 310 (E-364), 6. Dezember 1985 (1985-12-06) & JP 60 145660 A (MITSUBISHI DENKI KK), 1. August 1985 (1985-08-01)
- PATENT ABSTRACTS OF JAPAN vol. 14, no. 133 (E-0902), 13. März 1990 (1990-03-13) & JP 02 001985 A (MITSUBISHI ELECTRIC CORP), 8. Januar 1990 (1990-01-08)
- YAMASHITA J ET AL: "A NOVEL EFFECTIVE SWITCHING LOSS ESTIMATION OF NON-PUNCHTHROUGH ANDPUCHNTROUGH IGBTS" IEEE INTERNATIONAL SYMPOSIUM ON POWER SEMICONDUCTOR DEVICES AND ICS,US,NEW YORK, NY: IEEE, Bd. CONF. 9, 1997, Seiten 109-112, XP000800169 ISBN: 0-7803-3994-0
- BURNS D ET AL: "NPT-IGBT - OPTIMIZING FOR MANUFACTURABILITY" PROCEEDINGS OF THE INTERNATIONAL SYMPOSIUM ON POWER SEMICONDUCTOR DEVICES AND IC'S (ISPSD),US,NEW YORK, IEEE, Bd. SYMP. 8, 1996, Seiten 331-334, XP000598450 ISBN: 0-7803-3107-9

## Beschreibung

### Technisches Gebiet

Die Erfindung bezieht sich auf das Gebiet der Leistungsgelektronik. Sie bezieht sich auf ein Verfahren zur Herstellung eines Halbleiterelementes gemäss Oberbegriff des Patentanspruches 1.

### Stand der Technik

Um bestmögliche elektrische Charakteristiken von Halbleiter-Leistungsschaltern, wie zum Beispiel eines IGBT (Insulated Gate Bipolar Transistor) zu erzielen, muss die Dicke der aktiven Zone eines Halbleiterelementes so nahe wie möglich an den physikalischen Materialgrenzen gewählt werden.

Beispielweise hat die Dicke einen direkten Einfluss auf die Durchlassverluste. Im Falle von Durchbruchspannungen von 600 - 1800 V sind deshalb Dicken des Halbleiterelementes von 60 - 250 µm wünschenswert. Derartig geringe Dicken stellen jedoch in der Produktion der Halbleiterelemente ein grosses Problem dar, da Wafer mit einem Durchmesser von 100 mm und mehr eine Dicke von mindestens 300 µm aufweisen sollten, um die Bruchgefahr bei der Herstellung zu minimieren.

Bisher wurde dieses Problem durch die sogenannte Epitaxie-Technik gelöst. Dabei wird auf einem Trägersubstrat mit einer relativ grossen Dicke von 400 - 600 µm eine elektrisch aktive Zone gezüchtet. Das Träger-Substrat gewährleistet dabei dem entstandenen Halbleiterelement einerseits die notwendige Stabilität, andererseits bildet das Substrat die Anode des Halbleiterelementes.

Im allgemeinen ist zwischen Trägersubstrat und elektrisch aktiver Zone eine Stoppschicht, auch Buffer genannt, angeordnet. Die Stoppschicht dient im Blockierfall dazu, das elektrische Feld abrupt vor der Anode abzubremsen und damit von dieser fern zu halten, da, sollte das elektrische Feld die Anode erreichen, das Halbleiterelement zerstört wird. Die Züchtung der aktiven Zone ist ein langwieriges und kompliziertes Verfahren, so dass diese Epitaxie-Technik relativ teuer ist. Ferner weist diese Technik den Nachteil auf, dass es nicht möglich ist, das Trägersubstrat, das heisst die Anode, genügend schwach zu dotieren. Dies wäre jedoch von Vorteil, da die Anode eines Leistungshalbleiterelementes möglichst schwach dotiert sein sollte, damit dieses ideale elektrische Eigenschaften erhält. Eine schwache Dotierung bedeutet jedoch eine hohe Resistivität, was bei der relativ grossen Dicke des Trägersubstrates zu einem nicht vernachlässigbaren Widerstandswert führen würde.

Es ist deshalb ein neueres Verfahren zur Herstellung eines Halbleiterelementes bekannt, welches keine Epitaxie-Schichten benötigt. Derartige Verfahren sind beispielsweise bekannt aus Darryl Burns et al., NPT-IGBT-Optimizing for manufacturability, IEEE, Seite 109-112, 0-7803-3106-0/1996; Andreas Karl, IGBT Modules Reach New Levels of Efficiency, PCIM Europe, Issue 1/1998, Seite 8-12 und J. Yamashita et al., A novel effective switching loss estimation of nonpunchthrough and punchthrough IGBTs, IEEE, Seite 331-334, 0-7803-3993-2/1997. Die mit diesem Verfahren hergestellten Halbleiterelemente werden als NPT (non-punch-through) bezeichnet, im Gegensatz zu den punch-through Halbleiterelementen gemäss dem Epitaxie-Verfahren.
Bei diesem Verfahren dient ein relativ dicker Wafer ohne Epitaxieschicht als Ausgangsmaterial. Typische Dicken liegen bei 400 - 600 µm. In einem ersten Schritt wird der Wafer kathodenseitig behandelt, das heisst, es werden Photolitograhie, Ionenimplantation, Diffusionen, Ätzungen und sonstige für die Herstellung des Halbleiterelementes notwendigen Prozesse durchgeführt. In einem zweiten Schritt wird der Wafer auf der der Kathode entgegengesetzten Seite auf seine gewünschte Dicke reduziert. Dies erfolgt durch übliche Techniken, im allgemeinen durch Schleifen und Ätzen. In einem dritten Schritt wird nun auf dieser reduzierten Seite eine Anode eindiffundiert.

Obwohl sich dieses Verfahren gegenüber dem Epitaxieverfahren durch seine geringeren Kosten auszeichnet, weist es doch auch mehrere Nachteile auf:
Die Diffusion der Anode ist relativ schwierig, da in diesem Verfahrensschritt der Wafer bereits sehr dünn ist und somit leicht brechen kann. Zudem darf das Element nicht mehr stark erhitzt werden, da im ersten Verfahrensschritt bereits kathodenseitig Metallschichten aufgebracht worden sind, welche bei Temperaturen über 500 °C schmelzen. Somit lässt sich nur eine geringe Dotierung der Anode erzielen. Dies könnte sich zwar positiv auf die elektrischen Eigenschaften des Halbleiterelementes auswirken. Da es jedoch nicht gelingt, eine genügend starke Dotiermenge einzubauen, welche als Buffer dienen könnte, muss das Halbleiterelement genügend dick sein, damit im Sperrbetrieb ein Lawinenzusammenbruch erfolgt, bevor das elektrische Feld die Anode erreicht. Grundsätzlich sind derartig hergestellte Halbleiterelemente somit dicker als nach der Epitaxie-Technik hergestellten Elemente. Dadurch ist der Vorteil der schwach dotierten Anode durch die eingangs erwähnten Nachteile einer zu dicken aktiven Zone zumindest teilweise aufgehoben.

In EP-A-0'700'095 ist ferner ein abschaltbarer Thyristor offenbart, welcher für hohe Blockierspannungen geeignet ist. Er besteht aus einem Halbleiterelement mit einer Anode und einer Kathode, wobei die Anode einen transparenten Emitter aufweist. Derartige Anodenemitter sind bereits für Bauelemente mit geringer Leistung wie Solarzellen, Dioden oder Transistoren bekannt. Unter einem transparenten Anodenemitter versteht man einen anodenseitigen Emitter mit vergleichsweise schwacher Injektion, so dass hohe Anteile des von der Kathode kommenden Elektronenstroms rekombinationslos und damit ohne Auslösung eines injizierten Loches extrahiert werden können. Diesem transparenten Anodenemitter ist eine Stoppschicht vorgelagert, welche zum einen im Sperrbetrieb das elektrische Feld reduziert, zum anderen aber auch dazu dienen kann, die Injektionseffizienz der transparenten Anode zu beeinflussen. Die Stoppschicht wird dabei entweder eindiffundiert oder epitaktisch erzeugt, wobei das Dotierprofil im ersten Fall eine Gauss'sche Verteilung und im zweiten Fall eine über die Schichtdicke homogene beziehungsweise stufenförmige Verteilung aufweist. Obwohl dieses Halbleiterelement im Betriebszustand ein positives Verhalten aufweist, lässt es sich aufgrund der Bruchgefahr ebenfalls nicht beliebig dünn herstellen.

Für einfach aufgebaute, bipolare Leistungsbauelemente (Dioden, Thyristoren) sind Herstellverfahren bekannt, die zu vergleichweise niedriegen Dicken der n-Basiszone auf einkristallinem Wafermaterial führen. Beispielhaft aus der JP 60-145860 ist ein Verfahren zur Erzielung vergleichsweise niedrige Dicken der n-Basiszone unter Verwendung von einkristallinem Material bekannt. Hierzu wird der Prozess mit einer beidseitigen tiefen n-Diffusion gestartet. Danach werden wechselseitig Prozessschritte auf Vorder-(Waferabdünnen, p-Diffusion) und Rückseite (Waferabdünnen, p-Diffusion) ganzflächig ausgeführt. Die Erzeugung/Fotolithografie der n+ Emitter und der Kontaktgebiete, der Passievierungen sowie der Metallisierung auf der Vorderseite erfolgt bei einer bereits vor diesen Verfahrensschritten erreichten Waferdicke. Auf Grund der vergleichsweise groben Strukturen der genannten Bauelement, der einfachen Technologie (kein MOS-Komplex) und der Zeitpunkt der Offenlegung verwendeten geringen Waferdurchmesser von 4 bzw. 5 Zoll, stellen die somit zu handhabenden Waferdicken bei der Vorderseitenbearbeitung kein Problem dar. Für komplexere Leistungshalbleiterbauelemente wie z.B. IGBTs, die mit komplizierten Prozessschritten, kleinen Strukturabmessungen (Stepperlithografie) und der Verwendung von mindestens 6 oder 8 Zoll Wafern hergestellt werden, ist der Anwendung der hier offen gelegten Herstellungsmethode nicht mehr möglich.

### Darstellung der Erfindung

Es ist deshalb Aufgabe der Erfindung, ein möglichst dünnes Halbleiterelement zu schaffen, welches kostengünstig herstellbar ist.

Diese Aufgabe löst ein Verfahren mit den Merkmalen des Patentanspruches 1.

Das erfindungsgemässe Verfahren kombiniert die Vorteile eines mittels Epitaxie-Technik und eines mittels NPT-Technik hergestellten Halbleiterelementes, wobei ein Halbleiterelement geschaffen wird, welches sich in seinen elektrischen Eigenschaften von den mit diesen zwei bekannten Verfahren hergestellten Halbleiterelementen klar abhebt.

Erfindungsgemäss wird wie in der NPT-Technik ohne Epitaxieschichten gearbeitet, wobei vor der kathodenseitigen Behandlung des Ausgangsmaterials eine Stoppzone eingebracht wird. Die Einbringung der Stoppzone erfolgt von einer der zukünftigen Kathode entgegengesetzten Seite des Wafers mittels Dotierung, wodurch ein Dotierprofil entsteht, dessen Dichte zur zukünftigen Anode hin zunimmt und welches ein abgeschnittenes Dotierprofil aufweist. Nach kathodenseitiger Prozessierung wird der Wafer so weit gedünnt, dass das Dotierprofil bis auf eine niedrig dotierte Endzone entfernt wird, welche im wesentlichen die Stoppzone bildet. Anschliessend lässt sich eine schwach dotierte Anode, vorzugsweise mit einem transparenten Anodenemitter, herstellen, welche durch die benachbarte, vorzugsweise angrenzende Stoppzone, im Sperrbetrieb vor dem elektrischen Feld geschützt ist.

Vorteilhaft ist ferner, dass das erfindungsgemäss hergestellte Halbleiterelement 6 im Gegensatz zu den Elementen der Epitaxie-Technik einen positiven Temperaturkoeffizienten des Spannungsabfalls im Durchlassbetrieb aufweist.

Das erfindungsgemässe Verfahren lässt sich zur Herstellung der verschiedenartigsten Halbleiterelemente, insbesondere für IGBTs (Insulated Gate Bipolar Transistor), GTOs (Gate turn-off Thyristor) oder konventionelle Thyristoren verwenden.

Weitere vorteilhafte Ausführungsformen gehen aus den abhängigen Patentansprüchen hervor.

### Kurze Beschreibung der Zeichnungen

Im folgenden wird das erfindungsgemässe Verfahren und der damit hergestellte Gegenstand anhand eines bevorzugten Ausführungsbeispiels, welches in den beiliegenden Zeichnungen dargestellt ist, näher erläutert. Es zeigen:
- Figur 1a - 1e: die Herstellung eines erfindungsgemässen Halbleiterelementes vom Ausgangsmaterial bis zum Endprodukt und
- Figur 2: eine graphische Darstellung eines Diffusionsprofils sowie des elektrischen Feldes im Sperrbetrieb entlang dem Schnitt A- A' gemäss Figur 1b bzw. dem Schnitt A-B gemäss Figur 1e.

### Wege zur Ausführung der Erfindung

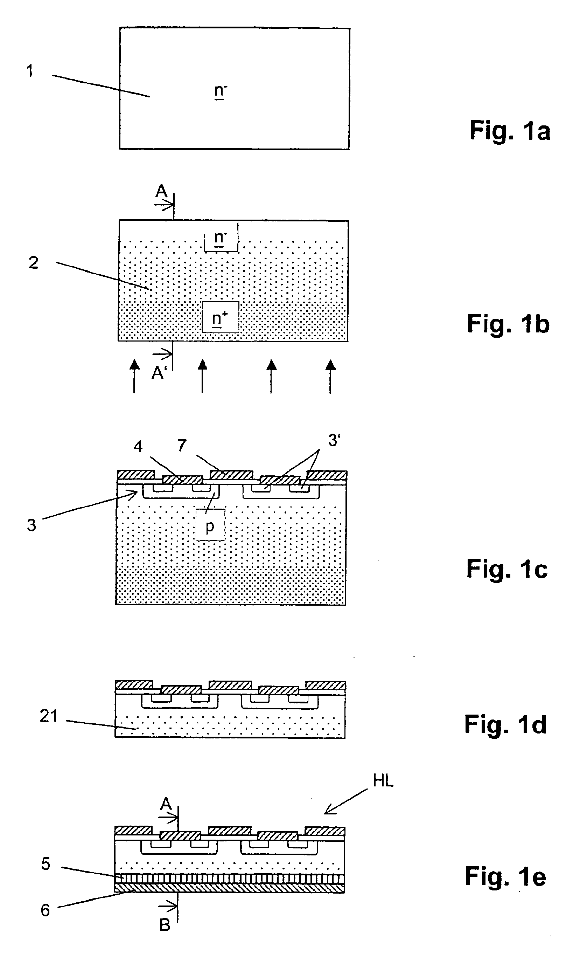

Wie in den Figuren 1a bis 1e dargestellt ist, wird das erfindungsgemäß hergestellte Halbleiterelement aus einem einstückigen, vorzugsweise uniform n⁻-dotierten Wafer 1 hergestellt (Figur 1a). Der Wafer 1 in seiner Form als Ausgangsmaterial ist relativ dick, wobei die Dicke so bemessen ist, dass sie die Bruchgefahr beim Handhaben des Wafers 1 minimiert. Typische Werte liegen bei 400 - 600 µm.

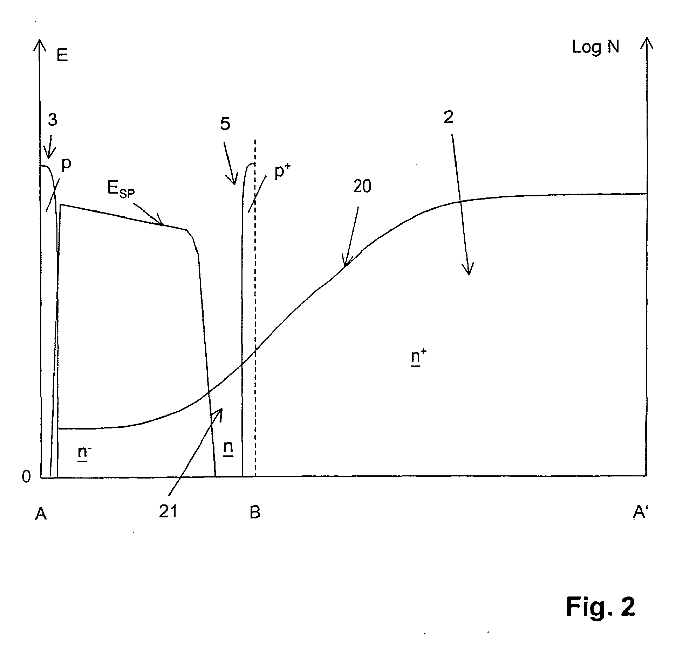

In einem ersten Verfahrensschritt wird der Wafer 1 von einer Seite her n⁺-dotiert, wobei hierfür bekannte Techniken, wie Ionen-Implantation mit anschliessender Diffusion, Belegung mit anschliessender Diffusion oder Diffusion aus der Gasphase, verwendet werden. Wie in Figur 1b mit Pfeilen dargestellt ist, erfolgt die Dotierung einseitig. Es ist jedoch auch möglich, den Wafer zweiseitig zu dotieren, wobei in diesem Fall der Wafer anschliessend auf einer Seite reduziert wird. Im Wafer 1 resultiert ein Diffusionsgebiet 2 mit einem Dotierprofil 20, welches quellenseitig zunimmt (Figur 2), wobei es von einer niedrig n-dotierten Zone in eine hochdotierte n⁺-Zone übergeht. Die Form des Dotierprofils hängt von der Herstellungstechnik ab, im allgemeinen ist sie gaussförmig oder entspricht einer komplementären Fehlerfunktion.
Die Eindringtiefe ist relativ hoch, vorzugsweise reicht sie über mindestens die halbe Dicke des Wafers 1, jedoch nicht bis zur gegenüberliegenden Seite. Die Dotierung ist in Figur 1b punktiert dargestellt, wobei die Dichte der Punkte schematisch die Dotierungsdichte kennzeichnen. Vorzugsweise ist das Dotierprofil jedoch im Gegensatz zur Darstellung gemäss Figur 1b stufenlos.
Durch die Wahl der Eindringtiefe sowie der Steigung des Dotierprofils 20 lässt sich die Dicke des resultierenden Halbleiterelementes vordefinieren, wie später erläutert wird. Die Diffusion erfolgt im allgemeinen bei einer relativ hohen Temperatur, vorzugsweise bei über 1200°C. Durch die grosse Eindringtiefe ist eine relativ lange Diffusionszeit, im allgemeinen über mehrere Tage, notwendig.

In einem nächsten Schritt wird die nicht diffundierte Seite des Wafers 1 behandelt, wobei eine Kathodenstruktur 3 mit einer n⁺-dotierten Kathode 3', eine Kathodenmetallisierung 4 und vorzugweise eine Steuerelektrode 7 mittels bekannter Prozesse auf- beziehungsweise eingebracht wird. Diese Prozesse etnsprechen den bei der NPT-Technik beschriebenen und werden hier deshalb nicht mehr ausführlich erläutert. Je nach Typ des herzustellenden Halbleiterelementes unterscheiden sich diese Prozesse, so wie sich auch die daraus entstehenden Strukturen der aktiven Zone 3 unterscheiden. Das in Figur 1c dargestellte Ergebnis einer derartigen kathodenseitigen Behandlung ist deshalb lediglich ein Beispiel von vielen Möglichkeiten.

In einem nächsten Schritt wird nun der Wafer 1 auf der der Kathodenmetallisierung 4 entgegengesetzten Seite in seiner Dicke reduziert, vorzugsweise durch Schleifen und Ätzen, wie dies in der NPT-Technik durchgeführt wird. Vorzugsweise wird dabei das gesamte Diffusionsgebiet 2 bis auf eine niedrig n-dotierte Endzone entfernt, welche mindestens annähernd eine Stoppzone 21 bildet.

In einem letzten Schritt (Figur 1e) wird auf der reduzierten Seite des Wafers 1 eine Anode mit einem transparenten Anodenemitter eingebracht, indem eine Randzone entsprechend dotiert wird. Diese Randzone ist im Vergleich zur Dicke des resultierenden Halbleiterelementes schmal. Der Anodenemitter, welcher im hier dargestellten Fall die gesamte Anode bildet, wird dabei p⁺-dotiert, wobei die Flächenbelegung mit p-Dotieratomen an der Anode weniger als 2x10¹⁴ cm⁻², vorzugsweise weniger als 1x10¹³ cm⁻² beträgt. Je nach Typ des Halbleiterelementes weist die Anode verschiedenartige Strukturen auf. Anschliessend lässt sich auch auf dieser Seite eine zweite Metallschicht, die Anodenmetallisierung 6, zur Kontaktierung anbringen. Vorzugsweise wird zum Schluss die Anodeneffizienz durch Bestrahlung mit hochenergetischen Ionen in die Anode 5 und den an die Anode 5 angrenzenden Teil der Stoppschicht 21 reduziert.

Es entsteht, wie Figur 1e zeigt, ein Halbleiterelement HL mit einer Kathodenstruktur 3 mit zugehöriger Kathodenmetällisierung 4 und Steuerelektrode 7, einer Anode 5 mit zugehöriger Anodenmetallisierung 6 und einer der Anode 5 benachbarten, vorzugsweise an diese angrenzende Stoppzone 21, welche ein zur Anode 5 hin abgeschnittenes Dotierungsprofil aufweist. Das erfindungsgemäß hergestellte Halbleiterelement HL weist jedoch eine relativ geringe Dicke auf, typischerweise 80 - 180 µm, wobei die Dicke von der Spannungsklasse des Halbleiterelementes abhängt.

In Figur 2 erkennt man das Gesamtprofil der wesentlichen Dotierungen des erfindungsgemäß hergestellten Halbleiterelementes HL:
Die Strecke von A nach A' in der Ordinate zeigt den Wafer 1 in seiner ursprünglichen Dicke, die Strecke von A nach B die Dicke des fertiggestellten Halbleiterelementes HL. Die Abszisse zeigt einerseits das elektrische Feld, andererseits ist sie logarhythmisch und stellt die Anzahl Dotieratome pro cm³ dar.
Wie man aus Figur 2 erkennt, wird das n⁻-dotierte Ausgangsmaterial im ersten Verfahrensschritt zur implantierten oder dotierten Seite hin durch eine n- beziehungsweise n⁺-Dotierung abgelöst, wobei die Dichte zur dotierten Seite hin zunimmt. Bei der Reduktion der Waferdicke wird die verbleibende dotierte Endzone, das heisst die Sperrzone 21, so dimensioniert, dass im Sperrbetrieb des Halbleiterelementes ein Lawinenzusammenbruch erfolgt, bevor das elektrische Feld die Anode 5 erreicht hat. Um den Emitter-Wirkungsgrad zu optimieren, ist die Dotierung der Stoppzone so stark gewählt, dass anodenseitig eine Spitzendotierung von mindestens 5x10¹⁴ cm⁻³, vorzugsweise 1x10¹⁵ cm⁻³, und maximal 6x10¹⁶ cm⁻³, vorzugsweise 1x10¹⁶ cm⁻³, erreicht wird. Dies ist in diesem Beispiel vor der Stelle = Punkt B - Dicke der Anode 5 der Fall, wobei Punkt B die Dicke des fertiggestellten Halbleiterelementes gemäss Figur 1e darstellt.

Figur 2 zeigt zudem das elektrische Feld im Sperrbetrieb.

Das erfindungsgemässe Verfahren ermöglicht somit die Herstellung von dünnen Leistungshalbleiterelementen mit einer transparenten Anode und einer integrierten Stoppschicht.

### Bezugszeichenliste

- 1: Wafer
- 2: Diffusionsgebiet
- 20: Dotierprofil
- 21: Stoppzone
- 3: Kathodenstruktur
- 3': Kathode
- 4: Kathodenmetallisierung
- 5: Anode
- 6: Anodenmetallisierung
- 7: Steuerelektrode
- HL: Halbleiterelement
- E_{SP}: Elektrisches Feld im Sperrbetrieb

## Patentansprüche

1. Verfahren zur Herstellung eines Halbleiterelementes (HL) mit einer Kathode (3) und einer Anode (5) aus einem Wafer (1), **gekennzeichnet durch** folgende aufeinander folgende Verfahrensschritte:
a) Behandlung des Wafers (1) zur Erzeugung einer anodenseitigen Stoppzone (21),
b) kathodenseitige Behandlung des Wafers (1) zur Erzeugunge einer Kathodenstruktur (3)
c) Reduktion der Dicke des Wafers (1) auf der der Kathode (3') entgegengesetzten Seite (Anodenseite)
d) Erzeugung einer Anode (5).

2. Verfahren nach Anspruch 1, **dadurch gekennzeichnet, dass** die Dicke des Wafers (1) im Schritt c) derart reduziert wird, dass mindestens ein Teil der Stoppzone (21) erhalten bleibt.

3. Verfahren nach Anspruch 1, **dadurch gekennzeichnet, dass** der Wafer (1) zur Einbringung der Stoppzone (21) von der der Kathode (3') entgegengesetzten Seite dotiert wird, wobei das Dotierprofil (20) so gewählt wird, dass nach Reduktion der Waferdicke von der, der Kathode entgegengesetzten Seite her, mindestens eine Endzone übrigbleibt, die mindestens annähernd die Stoppzone (21) bildet.

4. Verfahren nach Anspruch 1, **dadurch gekennzeichnet, dass** dass die zur Erzeugung der Stoppzone (21) benötigte Diffusion bei einer Temperatur von mindestens 1200°C erfolgt.

5. Verfahren nach Anspruch 1, **dadurch gekennzeichnet, dass** eine Stoppzone (21) mit einer anodenseitigen Spitzendotierung von mindestens 5x10¹⁴ cm⁻³, vorzugsweise 1x10¹⁵ cm⁻³, und maximal 6x10¹⁶ cm⁻³, vorzugsweise 1x10¹⁶ cm⁻³, eingebracht wird.

## Claims

1. Method of manufacturing a semiconductor element (HL) having a cathode (3) and an anode (5) from a wafer (1), **characterized by** the following successive method steps:
a) the wafer (1) is treated to produce an anode-side barrier region (21),
b) the wafer (1) is treated on the cathode side to produce a cathode structure (3),
c) the thickness of the wafer (1) is reduced on the side opposite to the cathode (3') (anode side),
d) an anode (5) is produced.

2. Method according to Claim 1, **characterized in that** the thickness of the wafer (1) is reduced in step c) such that at least part of the barrier region (21) is retained.

3. Method according to Claim 1, **characterized in that**, to add the barrier region (21), the wafer (1) is doped from the side opposite to the cathode (3'), the doping profile (20) being chosen such that, after reduction of the wafer thickness starting from the side opposite to the cathode, at least one end region remains which at least approximately forms the barrier region (21).

4. Method according to Claim 1, **characterized in that** the diffusion required for producing the barrier region (21) takes place at a temperature of at least 1200°C.

5. Method according to Claim 1, **characterized in that** a barrier region (21) having an anode sided peak doping of at least 5×10¹⁴ cm⁻³, preferably 1×10¹⁵ cm⁻³, and at most 6×10¹⁶ cm⁻³, preferably 1×10¹⁶ cm⁻³, is added.

## Revendications

1. Procédé pour fabriquer à partir d'une galette (1) un élément semi-conducteur (HL) doté d'une cathode (3) et d'une anode (5),
**caractérisé par** les étapes de traitement successives suivantes :
a) traitement de la galette (1) pour former une zone d'arrêt (21) sur le côté anodique,
b) traitement du côté cathodique de la galette (1) pour former une structure de cathode (3),
c) réduction de l'épaisseur de la galette (1) sur le côté opposé à celui de la cathode (3') (côté anodique) et
d) formation d'une anode (5).

2. Procédé selon la revendication 1, **caractérisé en ce que** l'épaisseur de la galette (1) est réduite à l'étape c) de manière à ce qu'au moins une partie de la zone d'arrêt (21) soit conservée.

3. Procédé selon la revendication 1, **caractérisé en ce que** pour réaliser la zone d'arrêt (21), la galette (1) est dopée sur le côté opposé à celui de la cathode (3'), le profil de dopage (20) étant sélectionné de telle sorte qu'après réduction de l'épaisseur de la galette, partant du côté opposé à la cathode, au moins une zone terminale qui forme au moins approximativement la zone d'arrêt (21) soit conservée.

4. Procédé selon la revendication 1, **caractérisé en ce que** la diffusion nécessaire pour former la zone d'arrêt (21) s'effectue à une température d'au moins 1 200°C.

5. Procédé selon la revendication 1, **caractérisé en ce qu'**il réalise une zone d'arrêt (21) dont le dopage de pointe côté anodique est d'au moins 5 x 10¹⁴ cm⁻³, de préférence de 1 x 10¹⁵ cm⁻³, d'au plus 6 x 10¹⁶ cm⁻³ et de préférence de 1 x 10¹⁶ cm⁻³.
